# EUROPEAN PATENT APPLICATION

(11) **EP 2 119 809 A1**
(43) Date of publication of application: **18.11.2009**
(21) Application number: 08156192.0
(22) Date of filing: 14.05.2008
(51) Int. Cl.: C23C 14/34, C23C 14/56

(54) **Substrate processing module exchange unit.**

(71) Applicant: Applied Materials, Inc., Santa Clara, CA 95054 (US)
(72) Inventor: Henrich, Jürgen, 63694 Limeshain (DE)
(74) Representative: Zimmermann & Partner

(57) **Abstract**

It is provided a substrate processing module exchange unit (40) for a vacuum coating installation (10) having at least one compartment with one or more substrate processing modules mounted and with a module port (18), the module exchange unit comprising a vacuum chamber (42), the vacuum chamber comprising a module exchange aperture (50) and a vacuum-tight unit connection means (53) adapted for establishing a vacuum-tight connection between the module exchange aperture and the compartment around the module port, wherein the vacuum chamber is sized for including at least two substrate processing modules.

## Description

### TECHNICAL FIELD OF THE INVENTION

The present invention relates to coating installations and applications. More particularly, the present invention relates to a substrate processing module exchange unit, a vacuum coating installation, a method of exchanging a substrate processing module of a vacuum coating installation, and a use of a substrate processing module exchange unit.

### BACKGROUND OF THE INVENTION

Thin-film coating of material on substrates may be accomplished in many ways, for example by evaporation or sputtering of the coating material.

In known installations for coating substrates with thin layers by cathode sputtering, several vacuum compartments are located one after another. Each compartment may comprise at least one sputtering cathode and process gas inlets, and is connected with a vacuum pump for evacuation. The compartments may be connected to one another by means of openings, typically vacuum locks which may comprise one or more slit valves. This design allows for a continuous or discontinuous transport of the substrates through the subsequent compartments.

A sputtering cathode or a plurality of sputtering cathodes may be mounted on a platform, resulting in a sputtering cathode module. The platform is for instance a vacuum flange which itself may be mounted on a vacuum flange of a compartment. When operating a sputtering cathode, a plasma is established and ions of the plasma are accelerated onto a target of coating material to be deposited onto the substrates. This bombardment of the target results in ejection of atoms of the coating material, which accumulate as a deposited film on the substrate below the sputtering cathode. Such a sputtering processing requires a vacuum or even a high or ultra high vacuum inside the compartment, in order to avoid contamination of the substrate.

In known vacuum coating installations for sputtering substrates, the sputtering cathodes or other substrate processing devices have to be exchanged from time to time. To this end, at least the compartment in which the sputtering cathodes to be exchanged are located has to be vented to atmospheric pressure. Thereafter, the sputtering cathode(s) or the sputtering cathode module(s), respectively, are removed from the compartment and replaced by another sputtering cathode(s) or module(s). In order to resume sputtering processing, the compartment has to be evacuated again to establish vacuum pressure. In some instances heating of the compartment is required, in order to accelerate desorption of contaminants which were adsorbed on the inside surfaces of the compartment and of the sputtering cathode modules during exchange of the sputtering cathode(s).

A known exchange procedure as described above may take 10 to 12 hours. During this time period the coating installation cannot be operated, resulting in high service expenses.

### SUMMARY OF THE INVENTION

In light of the above, the substrate processing exchange module unit according to independent claim 1, the vacuum coating installation according to independent claim 8, and the method of exchanging a substrate processing module of a vacuum coating installation according to independent claim 11 are provided.

In one embodiment it is provided a substrate processing module exchange unit for a vacuum coating installation having at least one compartment with one or more substrate processing modules mounted and with a module port, the module exchange unit comprising a vacuum chamber, the vacuum chamber comprising a module exchange aperture and a vacuum-tight unit connection means adapted for establishing a vacuum-tight connection between the module exchange aperture and the compartment around the module port, wherein the vacuum chamber is sized for including at least two substrate processing modules.

A further embodiment is directed to a vacuum coating installation having at least one compartment with one or more substrate processing modules mounted and with a module port, comprising a substrate processing module exchange unit comprising a vacuum chamber, the vacuum chamber comprising a module exchange aperture and a vacuum-tight unit connection means adapted for establishing a vacuum-tight connection between the module exchange aperture and the compartment around the module port, the vacuum chamber being sized to include at least two substrate processing modules, wherein the compartment comprises compartment connection means adapted for establishing a vacuum-tight connection between the module exchange aperture of the substrate processing module exchange unit and the compartment around the module port.

According to yet another embodiment, a method of exchanging a substrate processing module of a vacuum coating installation having at least one compartment with one or more substrate processing modules mounted and with a module port comprises providing a substrate processing module exchange unit comprising a vacuum chamber having a module exchange aperture, establishing a vacuum-tight connection between the module exchange aperture of the substrate processing module exchange unit and the compartment of the vacuum coating installation around the module port, evacuating the vacuum-tight connection, exchanging a substrate processing module, and removing the substrate processing module exchange unit.

An additional embodiment is directed to a use of a substrate processing module exchange unit as defined above in a method of exchanging a substrate processing module of a vacuum coating installation.

Further advantages, features, and details are evident from the dependent claims, the description and the drawings.

Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.

It is contemplated that elements of one embodiment may be advantageously utilized in other embodiments without further recitation.

### BRIEF DESCRIPTION OF THE DRAWINGS

So that the manner in which the above recited features of the present invention can be understood in detail, a more particular description of embodiments of the invention, briefly summarized above, may be had by reference to embodiments. The accompanying drawings relate to embodiments of the invention and are described in the following. Some of the above mentioned embodiments will be described in more detail in the following description of typical embodiments with reference to the following drawings in which:

Fig. 1 shows a cross-sectional top view of a vacuum coating installation and another substrate processing module exchange unit according to embodiments described herein.

Fig. 2 is a cross-sectional top view of a modification of the vacuum coating installation shown in Fig. 1 and the substrate processing module exchange unit shown in Fig. 1.

Fig. 3 illustrates a cross-sectional top view of another vacuum coating installation and another substrate processing module exchange unit according to embodiments described herein.

Fig. 4 illustrates a cross-sectional top view of another vacuum coating installation and another substrate processing module exchange unit according to embodiments described herein.

Fig. 5 is a cross-sectional top view of a further vacuum coating installation and another substrate processing module exchange unit according to embodiments described herein.

Fig. 6 is a cross-sectional top view of another vacuum coating installation and another substrate processing module exchange unit according to embodiments described herein.

Fig. 7 illustrates a cross-sectional side view of the compartment and the corresponding module exchange unit shown in Fig. 1, along line A-A.

### DETAILED DESCRIPTION OF THE EMBODIMENTS

Reference will now be made in detail to the various embodiments, one or more examples of which are illustrated in the figures. Each example is provided by way of explanation, and is not meant as a limitation of the invention. Within the following description of the drawings, the same reference numbers refer to the same components. Generally, only the differences with respect to the individual embodiments are described.

Typically, applications of the substrate processing module exchange unit, of the vacuum coating installation, and of the method of exchanging a substrate processing module according to embodiments of the invention are in vacuum sputtering compartments of coating installations for coating substrates with thin films. Embodiments of the invention are useful, e.g., for service procedures on coating installations in which substrates, for instance rigid glass substrates, are coated with thin metal films by sputtering, for example with Ag films, for instance in the manufacture of solar cells. Embodiments of the present invention can also be applied to coating installations adapted for other coating methods, such as thin-film vapour deposition, and other coating materials than Ag, e.g. other metals or alloys. Furthermore, other substrates, for instance flexible substrates, such as webs or plastic films, or substrates having specific shapes, such as rectangular or circular plates, may be employed. Moreover, the substrate(s) may be delivered to the coating chamber continuously or may be provided in the coating installation in a discontinuous mode. Additionally, the coating installation may not be limited to a vacuum installation. Typical substrate processing modules which require an exchange from time to time are sputtering cathode modules. An exchange of a sputtering cathode module as carried out in the embodiments of the methods described herein is typically required when one or more cathodes or targets, respectively, of the sputtering cathode module are depleted or if the sputtering cathode module is defect.

Without limiting the scope of the invention, the following is directed to a substrate processing module exchange unit, a vacuum coating installation, a method of exchanging a substrate processing module, and a use of a substrate processing module exchange unit, wherein the substrate processing module is a sputtering cathode or a plurality of sputtering cathodes arranged on a platform, such forming a sputtering cathode module. In the following description, the platform is described as a vacuum flange. However, in some modifications, other flanges or sockets may be used as a platform. Moreover, as can be seen by the person skilled in the art, the substrate processing module exchange unit, the vacuum coating installation, and the method of exchanging a substrate processing module may also be used for installations not requiring vacuum conditions, for instance in coating installations for processes which are conducted under inert atmosphere. Hence, the substrate processing module exchange unit, the coating installation, and the method of exchanging a substrate processing module of the embodiments described herein may analogously be used for coating chambers operated under ambient pressure or under atmosphere, typically an inert atmosphere.

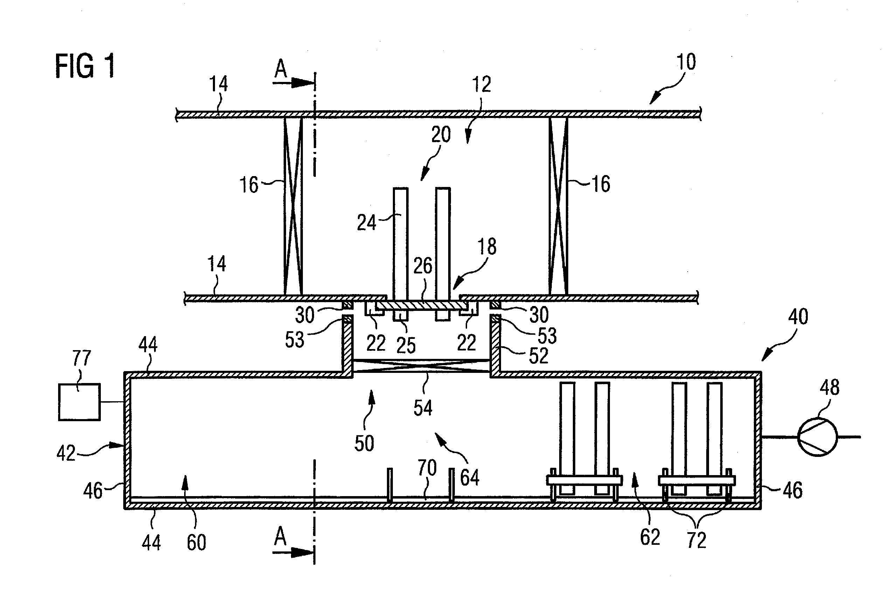

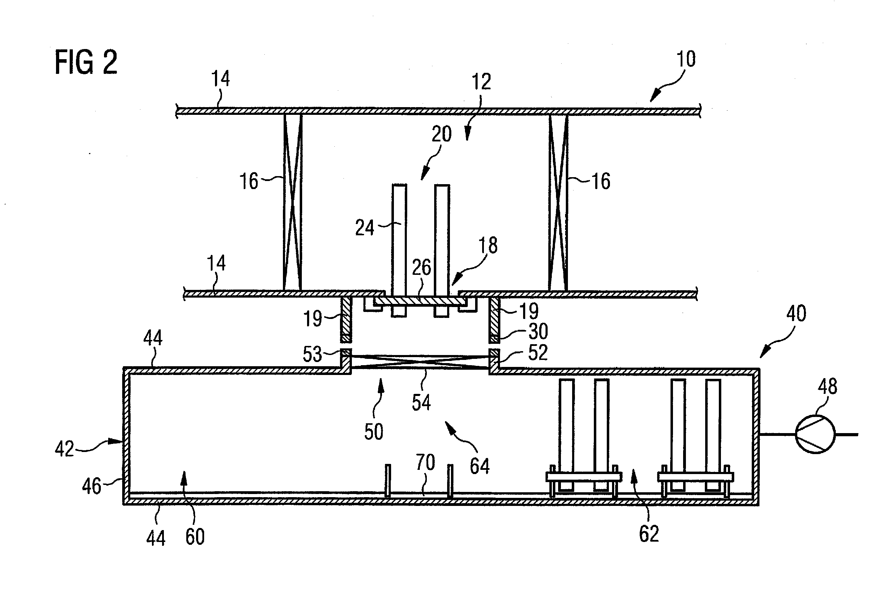

Fig. 1 and 2 illustrate each a cross-sectional top view of a vacuum coating installation and a substrate processing module exchange unit according to embodiments described herein.

According to one embodiment, a vacuum coating installation having at least one compartment with one or more substrate processing modules mounted and with a module port, comprises a substrate processing module exchange unit comprising a vacuum chamber, the vacuum chamber comprising a module exchange aperture and a vacuum-tight unit connection means adapted for establishing a vacuum-tight connection between the module exchange aperture and the compartment around the module port, the vacuum chamber being sized for including at least two substrate processing modules. Furthermore, the compartment typically may comprise compartment connection means adapted for establishing a vacuum-tight connection between the module exchange aperture of the substrate processing module exchange unit and the compartment around the module port.

According to examples of embodiments described herein, one of the substrate processing modules mounted is mounted at the module port, and one of the at least two substrate processing modules is to be mounted at the module port. That means, one substrate processing module to be exchanged may be mounted at the module port or is to be mounted at the module port. Further, one or more of the substrate processing modules may be a sputtering cathode or a plurality of sputtering cathodes provided on a platform. In addition, the platform may be a vacuum flange.

As shown in Fig. 1 and 2, a vacuum coating installation 10 according to embodiments described herein includes a plurality of compartments, one compartment thereof being a sputtering compartment 12. The sputtering compartment 12 has two parallel sidewalls 14, a bottom wall and a top wall (not shown in Fig. 1 and 2). The sputtering compartment 12 is connected to the adjacent compartments of the coating installation 10 by vacuum locks 16 which may comprise slit valves. Substrates to be coated may be conveyed through compartment 12 by transporting them through the vacuum locks 16. One sidewall 14 of the compartment 12 includes an opening 18 as a module port. On the opening 18, as a substrate processing module, a sputtering cathode module 20 is attached in a vacuum-tight manner, e.g. by using clamping fixtures 22 which may be automatically, pneumatically and/or electrically driven. The sputtering cathode module 20 includes two sputtering cathodes 24 mounted on a vacuum flange 26 and having as ports feed through ports 25 for water and current supply. Typically, opening 18 is part of a vacuum flange (not shown in the Figures).

Moreover, according to embodiments described herein, ports of the substrate processing module are typically vacuum-compatible. In one example, all ports of the substrate processing module typically are vacuum-compatible. Some of the ports of the substrate processing module, which are vacuum-compatible, are feed through ports and are for attaching the tubes and cables of the water and current supply of the sputtering cathodes. Therefore, in examples of embodiments described herein, it is possible to arrange the feed through ports 25 of the sputtering cathode module 20 in a vacuum atmosphere.

Compartment 12 shown in Fig. 1 includes a vacuum sealing 30 which is attached to the sidewall 14 around opening 18 in a vacuum-tight manner. In this example, vacuum flange 26, the opening 18 as well as the vacuum sealing 30 are circular. Moreover, according to the alternative example shown in Fig. 2, the sealing 30 may be attached to a free end of a vacuum flange 19 having a circular cross-section, being mounted to the sidewall 14 and encompassing the opening 18. Hence, the sealing 30 or alternatively, the sealing 30 and the flange 19 form the vacuum-tight compartment connection means of the compartment 12.

According to embodiments described herein, a substrate processing module exchange unit for a vacuum coating installation having at least one compartment with one or more substrate processing modules mounted and with a module port comprises a vacuum chamber, the vacuum chamber comprising a module exchange aperture and a vacuum-tight unit connection means adapted for establishing a vacuum-tight connection between the module exchange aperture and the compartment around the module port, wherein the vacuum chamber is sized for including at least two substrate processing modules. Moreover, the substrate processing module exchange unit may be adapted to be mobile or wheeled.

In examples of embodiments described herein, the unit connection means of the module exchange unit comprises a vacuum sealing which is mounted at the vacuum chamber around the module exchange aperture and corresponds to another vacuum sealing mounted at the compartment around the module port. Furthermore, in examples of embodiments described herein, the compartment connection means of the vacuum coating installation comprises a vacuum sealing which is mounted at the compartment around the module port and corresponds to another sealing mounted at the vacuum chamber of the substrate processing module exchange unit around the module exchange aperture.

As illustrated in the cross-sectional top views of Fig. 1 and 2, a substrate processing module exchange unit 40 according to embodiments described herein is designed as a mobile, elongated vacuum chamber 42. The vacuum chamber 42 has two elongated sidewalls 44, two sidewalls 46 connecting the sidewalls 44, top wall and a bottom wall (not shown in Fig. 1 and 2). In one of the sidewalls 44, an opening 50 is provided as a module exchange aperture surrounded by a flange 52 attached outside at the sidewall 44. The opening 50 is typically arranged in the centre of the corresponding sidewall 44. In this example, the opening 50 is circular and the flange 52 has a circular cross-section. Further, flange 52 includes at its free end a circular vacuum sealing 53 having a diameter corresponding to the diameter of the circular vacuum sealing 30 around opening 18 of compartment 12. Hence, sealing 53 and flange 52 are provided as a vacuum-tight unit connection means.

In other modifications of the present examples, the flange 52, the sealing 53 of the module exchange unit 40 and the sealing 30 of the compartment 12 may have other shapes, for instance non-circular, as long as they are able to form a vacuum tight connection between the vacuum chamber 42 and the compartment 12 around opening 50, i.e. around the module exchange aperture, and around opening 18, i.e. around the module port.

In order to evacuate the vacuum chamber 42, the interior thereof is typically connected to a vacuum pump 48 which may be connected to one sidewall 46. This allows for establishing a vacuum inside of the module exchange unit 40 and for testing whether the module exchange unit 40 is vacuum-tight and functioning.

Further, in examples of embodiments described herein, the unit connection means comprises a vacuum valve and/or a vacuum lock and/or a slit valve and/or an air valve and/or a vacuum pump. Moreover, in further examples of embodiments described herein, the compartment connection means comprises a vacuum valve and/or a vacuum lock and/or a slit valve and/or an air valve and/or a vacuum pump.

More specifically, in flange 52 of the module exchange unit 40, a vacuum valve 54 may be mounted, e.g. a gate valve or a slide valve, in order to block and unblock the opening 50 if necessary. In other modifications, instead, or in addition to vacuum valve 54, a vacuum lock and/or a slit valve may be arranged in flange 52. Furthermore, the unit connection means of the module exchange unit 40 may comprise an additional vacuum valve (not shown) or air valve (not shown). According to a typical example thereof, in a wall of flange 52 the additional vacuum valve or air valve is provided. This modification allows for an individual venting of the vacuum-tight connection between vacuum chamber 42 and compartment 12. Alternatively or additionally, the compartment connection means of the compartment, e.g. the flange 19 of Fig. 2, may comprise a vacuum valve or an air valve for venting the vacuum-tight connection between vacuum chamber 42 and compartment 12. In specific examples of the compartment connection means and/or the unit connection means, the additional vacuum valve or air valve is located near the free end of flanges 19 or 52, respectively. Examples of embodiments including a vacuum pump in the unit connection means and/or in the compartment connection means are described further below.

The vacuum chamber 42 of the module exchange unit 40 is sized to include at least two substrate processing modules. In one example, the vacuum chamber 42 comprises a first storage region 60 adapted for storing at least one exchanged substrate processing module of the at least two substrate processing modules, a second storage region 62 adapted for storing at least one substrate processing module to be mounted of the at least two substrate processing modules, and a region 64 adjacent to the module exchange aperture. The term exchanged substrate processing module is meant to include a dismounted substrate processing module. Since in the present example shown in Fig. 1 and 2, the module exchange aperture, i.e. the opening 50, is located in the centre of the sidewall 44, the region 64 is also located centrally inside the vacuum chamber 42. Hence, according to an example of embodiments described herein, region 64 is positioned between the first storage region 60 and the second storage region 62. In the examples as shown in Fig. 1 and 2, the first storage region is located to the left of region 64, and the second storage region is located to the right of region 64.

According to one example of embodiments described herein, the vacuum chamber of the module exchange unit (also referred to herein as substrate processing module exchange unit) comprises a transfer device adapted for transferring the substrate processing modules inside the vacuum chamber. In particular, the transfer device may transfer the substrate processing module between the first storage region and/or the second storage region and/or the region adjacent to the module exchange aperture. As illustrated in Fig. 1 and 2, the transfer device therefore may include a track 70 and bolts 72 provided to the track 70. The bolts 72 are in the examples of Fig. 1 and 2 arranged such that the platform of each sputtering cathode module to be exchanged may be pushed on typically two of the bolts 72 and held thereon. For transferring one of the sputtering cathode modules inside the vacuum chamber 42 from one of the regions 60, 62, and 64 to another, the bolts may be moved on the tracks 70 in a direction parallel to the elongated sidewalls 44.

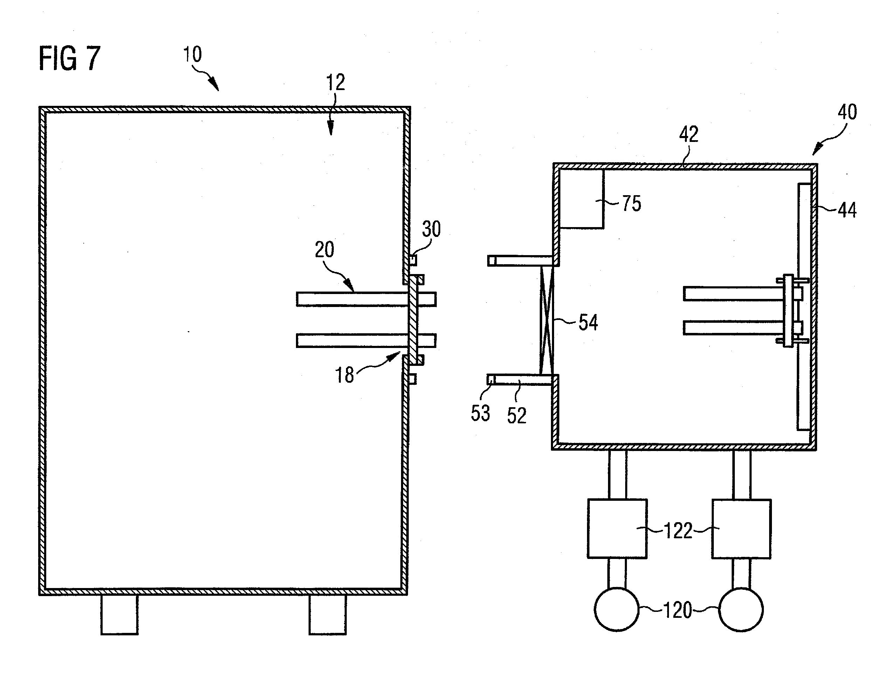

In one example of embodiments described herein, the vacuum chamber 42 is provided with manipulating means adapted for engaging and manipulating at least one substrate processing module and/or for dismounting at least one substrate processing module to be exchanged and/or for mounting at least one substrate processing module to be exchanged, i.e. for mounting at least one substrate processing module to be mounted. Such a manipulating means may be an electrically driven, vacuum-compatible manipulator 75 (not shown in Fig. 1; schematically shown in the cross-sectional view according to Fig. 7 along line A-A of Fig. 1). The manipulator 75 is in the examples shown in Fig. 1 and 7 located inside the vacuum chamber 42 near the region 64 adjacent to the opening 50. In another example, the manipulator 75 may be positioned in the vacuum-tight unit connection means of vacuum chamber 42, e.g. at an inside wall of the flange 52. In an alternative modification of the module exchange unit 40 and the vacuum coating installation 10, the manipulating means 75 may be positioned inside the vacuum-tight compartment connection means of the compartment 12, e.g. in flange 19 provided around the opening 18 as shown in Fig. 2. The manipulator 75 may be controllable from the outside of vacuum chamber 42 and/or from the outside of compartment 12, e.g. wireless, for instance by radio communication. Hence, by using the manipulator 75, the sputtering cathode module 20 mounted in opening 18 of the compartment 12 may be dismounted, transported through opening 50 of the vacuum chamber 42 into region 64. Furthermore, using the manipulator 75, a new sputtering cathode module which has been stored in second storage region 62 and transferred into region 64 of the vacuum chamber 42 may be transported through opening 50 of the module exchange unit to opening 18 of the compartment 12 and mounted there.

According to embodiments disclosed herein, a method for exchanging a substrate processing module of a vacuum coating installation having at least one compartment with one or more substrate processing modules mounted and with a module port, comprises providing a substrate processing module exchange unit comprising a vacuum chamber having a module exchange aperture, establishing a vacuum-tight connection between the module exchange aperture of the substrate processing module exchange unit and the compartment of the vacuum coating installation around the module port, evacuating the vacuum-tight connection, exchanging a substrate processing module, and removing the substrate processing module exchange unit. In particular, the step of exchanging a substrate processing module may include replacing one of the substrate processing modules mounted by another substrate processing module or a flange cap to be mounted. Moreover, the step of exchanging a substrate processing module may include replacing one of the substrate processing modules mounted or a flange cap mounted by a substrate processing module to be mounted. In addition, the step of exchanging a substrate processing module may include removing one of the substrate processing modules mounted at a module port without subsequent closing of the module port.

In variations of embodiments of the method for exchanging a substrate processing module of a vacuum coating installation, the step of exchanging a substrate processing module comprises at least one of the following steps: dismounting one of the substrate processing modules mounted and inserting the dismounted substrate processing module into the substrate processing module exchange unit in a region adjacent to the exchange aperture, transferring the dismounted substrate processing module into a first storage region adapted for storing at least one exchanged substrate processing module in the substrate processing module exchange unit, transferring in the substrate processing module exchange unit a substrate processing module to be mounted from a second storage region, which is adapted for storing at least one substrate processing module to be mounted, into a region adjacent to the exchange aperture of the substrate processing module exchange unit, and transporting the substrate processing module to be mounted to the module port and mounting the substrate processing module to be mounted. Furthermore, in other variations of the method for exchanging a substrate processing module of a vacuum coating installation, the substrate processing module mounted is dismounted from the module port and the substrate processing module to be mounted is mounted at the module port.

In the following, exemplified for the vacuum coating installations and the substrate processing module exchange units shown in Fig. 1 and 2, an example of the method for exchanging a substrate processing module according to embodiments disclosed herein is described. The vacuum chamber 42 of the module exchange unit 40 is provided with one or more new sputtering cathode modules in the second storage region 62. Then the opening 50 of the vacuum chamber 42 is shut by vacuum valve 54. Around vacuum chamber 42, an inert atmosphere may be established, e.g. using a source of inert gas and a curtain, and maintained during transport and/or exchange procedure. Vacuum chamber 42 is now evacuated, transported to opening 18 of the compartment 12 and positioned in front of the opening 18. A vacuum-tight connection between vacuum chamber 42 and compartment 12 is formed by connecting the vacuum sealing 30 of the compartment 12 to vacuum sealing 53 of the vacuum chamber 42. Then, vacuum valve 54 of the vacuum chamber 42 is opened while the vacuum pump 48 is operating. Thereby, the interior space of the vacuum-tight connection between vacuum chamber 42 and compartment 12 as well as the vacuum chamber 42 are evacuated to a pressure which approximately corresponds to the vacuum pressure inside compartment 12.

Consequently, in one variation of embodiments of the method for exchanging a substrate processing module of a vacuum coating installation, of the unit connection means and the compartment connection means at least the unit connection means comprises a vacuum valve, the substrate processing module exchange unit is evacuated before establishing the vacuum-tight connection, and the vacuum-tight connection is evacuated by opening the vacuum valve of the unit connection means.

After evacuation of the vacuum-tight connection in the examples illustrated in Fig. 1 and 2, the sputtering cathode module 20 mounted at the opening 18 of the compartment 12 is dismounted by opening the clamping fixtures 22 and using the manipulator 75 mentioned above. The dismounted sputtering cathode module 20 is transported by the manipulator 75 through flange 52 and the opening 50 into the vacuum chamber 42 of the module exchange unit 40. The sputtering cathode module 20 is then installed on two bolts 72 of the transfer device 70, 72 inside of the vacuum chamber 42, in the region 64 adjacent to opening 50. The transfer device 70, 72 moves the dismounted sputtering cathode module 20 into the first storage region 60 of vacuum chamber 42. After that, a new sputtering cathode module to be mounted is transferred inside the vacuum chamber 42 from the second storage region 62 to the region 64 adjacent to the opening 50. The manipulator 75 engages the new sputtering cathode and transports it through the opening 50 and the flange 52 to the opening 18 of the compartment 12. The new sputtering cathode module is then mounted by the manipulator 75 at the opening 18 in a vacuum-tight way using the clamping fixtures 22.

At least, after closing the vacuum valve 54, the vacuum-tight connection between the vacuum chamber 42 and the compartment 12 is vented by opening the above mentioned additional vacuum valve (not shown) provided in a wall of flange 52. The sealing 53 of flange 52 is then released from the sealing 30 of the compartment 12. Hence, for resuming coating operation in compartment 12, just the current and water supply connections needed for operating the new sputtering cathode module have to be installed at the feed through ports thereof. Thereafter, the module exchange unit 40 may be transported to another module port provided with a sputtering cathode module to be exchanged, while keeping a vacuum pressure inside of the vacuum chamber 42.

In a modification of the module exchange unit of embodiments disclosed herein, a heating device 77 (schematically shown in Fig. 1) may be provided. This heating device 77 may e.g. be a heating band attached to the outside walls of vacuum chamber 42. The heating device 77 is for enabling a cleaning procedure of the sputtering cathode modules during storage inside the vacuum chamber 42. Heating of the sputtering cathode modules to be mounted once or intermittently inside the vacuum chamber 42 while vacuum pump 48 is operating allows for desorption of contaminants, e.g. water, adsorbed at the sputtering cathode modules. Therefore, after installation of a sputtering cathode module at the compartment 12, a cleaning procedure for desorbing such contaminants inside the compartment 12 of the coating installation is not required. Consequently, the coating installation can be operated immediately after mounting the sputtering cathode module.

As can be seen from the above, when using the substrate processing module exchange unit, the vacuum coating installation, and/or the substrate processing module exchange procedure according to embodiments disclosed herein, there is no need for venting the compartment 12 of the vacuum coating installation 10. Moreover, in the module exchange unit 40 according to the examples of Fig. 1 and 2, the sputtering cathode modules to be mounted can be prepared for mounting and stored for a longer time period under vacuum pressure. More particularly, if a heating device as mentioned above is provided, the sputtering cathode modules may be heated and cleaned, for instance by desorbing contaminants, already during storage inside the module exchange unit. Furthermore, a leak and/or functional test of the sputtering cathode modules may be carried out inside the module exchange unit, i.e. before being mounted at the coating installation. In addition, the embodiments of a module exchange unit described herein may be used for substrate module exchange procedures or other service procedures on a plurality of module ports, flanges, compartments, and/or vacuum installations. Moreover, in the examples shown in Fig. 1 and 2, after connecting the module exchange unit 40 and the vacuum coating installation in a vacuum-tight manner as described above, only the interior space of the vacuum-tight connection has to be evacuated. This results in a short pumping period during the substrate processing module exchange procedure. Furthermore, the module exchange unit shown in Fig. 1 and 2 is vacuum compatible and has the capability of storing a plurality of substrate processing modules. Therefore, dismounting a sputtering cathode module to be exchanged from the compartment and mounting a new sputtering cathode module at the compartment can be carried out in one step under vacuum conditions. In summary, the whole procedure of exchanging a substrate processing module is shortened. Hence, the time period during which the coating installation cannot operate may be reduced to less than one hour, or even to less than half an hour. As a result, the total service expenses can be reduced markedly.

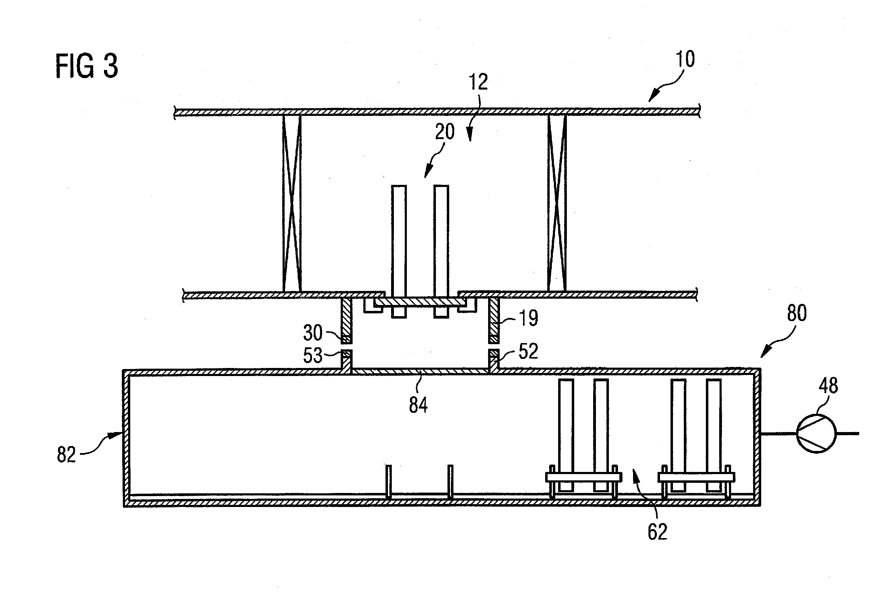

In Fig. 3, a cross-sectional top view of another example of a substrate processing module exchange unit according to embodiments disclosed herein is shown. The difference of this module exchange unit 80 as compared to the example shown in Fig. 2 is that the mobile vacuum chamber 82 of the module exchange unit 80 has a lid or a shutter 84 mounted inside flange 52 instead of the vacuum valve 54. In Fig. 3 lid 84 is schematically presented. Lid 84 may be a vertically or horizontally operating shutter, i.e. a shutter being movable in a direction parallel to sidewall 44. In the present example, lid or shutter 84 typically may not be vacuum-tight. Furthermore, lid or shutter 84 is for closing vacuum chamber 42 during transport from one module port of the vacuum coating installation 10 to another. That means that vacuum chamber 82 is in the present example transported under ambient pressure, typically under inert atmosphere.

In operation, i.e. for initiating a substrate processing module exchange procedure according to the present example shown in Fig. 3, the vacuum chamber 82, which includes in the second storage region 62 one or more new sputtering cathode modules, is transported to flange 19 while lid 84 is closed. Flange 52 of vacuum chamber 80 is connected to flange 19 of the compartment 12 by using the sealings 30 and 53, while lid 84 is closed. Thereby, a vacuum-tight connection between vacuum chamber 82 and compartment 12 is established. After that, lid 84 is opened and vacuum chamber 82 and the inside space of the vacuum-tight connection is evacuated using vacuum pump 48, until a vacuum pressure approximately corresponding to the pressure inside compartment 12 has been achieved. Optionally, in this stage of the procedure, a cleaning process may be carried out by heating vacuum chamber 80 for desorbing contaminants attached to the surfaces of the new sputtering cathode modules stored inside module exchange unit 80. After that, the sputtering cathode module 20 mounted at opening 18 is exchanged as described for the examples of Fig. 1 and 2 using the manipulator 75 provided. Finally, after the new sputtering cathode module has been mounted, vacuum chamber 82 of the module exchange unit 80 and the vacuum-tight connection are vented together. Then, the lid 84 is closed and module exchange unit 80 is dismounted from flange 19.

As can be seen from the above, when using in a substrate processing module exchange procedure the module exchange unit of Fig. 3, there is no need for venting the compartment 12 of the vacuum coating installation 10. Furthermore, dismounting a sputtering cathode module from the compartment and mounting a new sputtering cathode module at the compartment can be carried out in one step, because of the capability of the module exchange unit to store a plurality of substrate processing modules and because of its vacuum compatibility. Consequently, the whole procedure of exchanging a substrate processing module is shortened. Hence, the time period during which the coating installation cannot operate and the total service expenses can be reduced.

According to one example of embodiments of the method for exchanging a substrate processing module of a vacuum coating installation, the compartment connection means comprises a vacuum valve, and the vacuum-tight connection is evacuated by evacuating the substrate processing module exchange unit and the vacuum-tight connection together before the vacuum valve of the compartment connection means is opened.

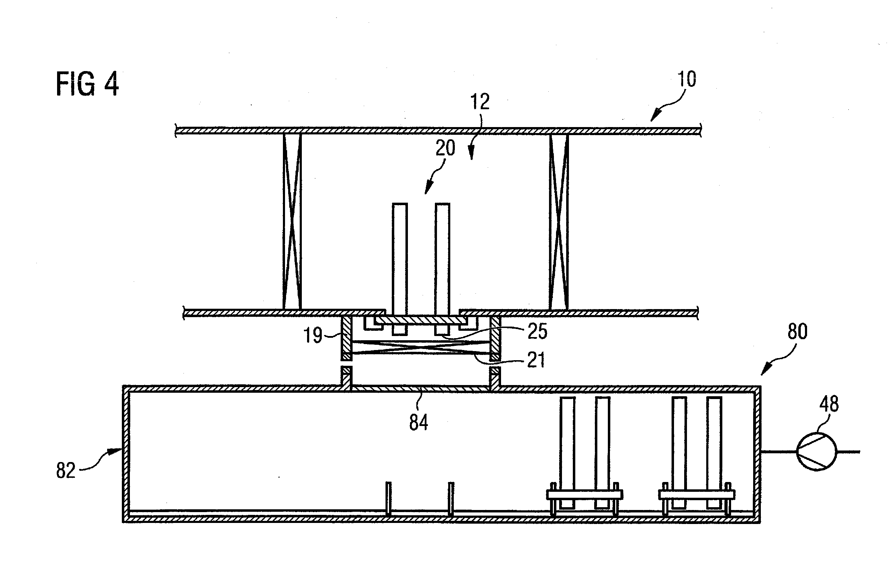

A variation of the example shown in Fig. 3 is illustrated in Fig. 4. In this variation, flange 19 of the compartment 12 includes a vacuum valve 21, e.g. a gate valve, a slide valve, a vacuum lock or a slit valve. Vacuum valve 21 is for closing compartment 12 for instance in cases of dismounting sputtering cathode module 20 from opening 18 without mounting another sputtering cathode module. Hence, vacuum valve 21 may be used for maintaining the vacuum pressure inside compartment 12, in case that opening 18 is not to be closed by a vacuum-tight flange of another sputtering cathode module or by a vacuum-tight flange cap after dismounting the sputtering cathode module 20. The difference in operation of this example, as compared to the operation of the example shown in Fig. 3, is that after removing the sputtering cathode module 20 and before venting the module exchange unit and the vacuum-tight connection together, the vacuum valve 21 is closed. After venting of the module exchange unit and the vacuum-tight connection, module exchange unit 80 is dismounted from flange 19 of the compartment 12.

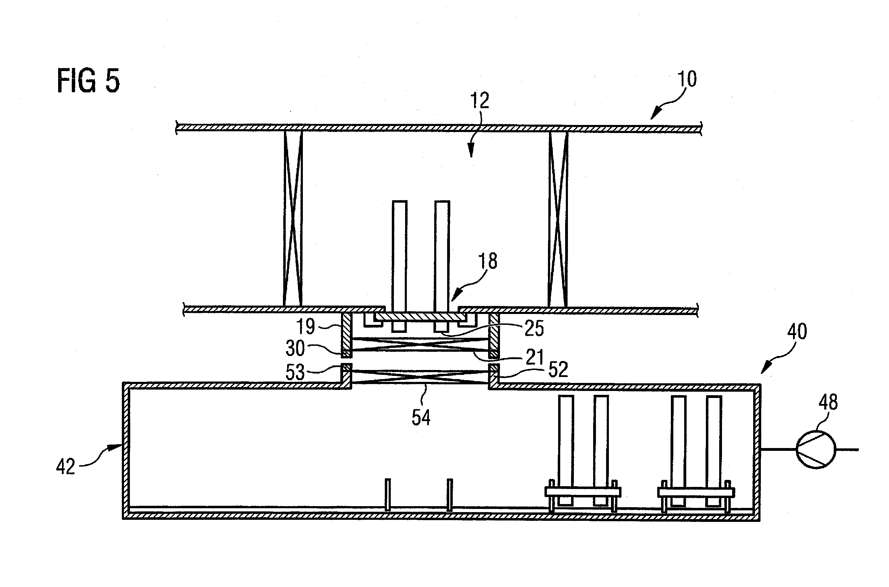

In another example of embodiments disclosed herein and illustrated in Fig. 5, the compartment 12 shown in Fig. 4 and the vacuum chamber 40 shown in Fig. 2 may be combined. That means that compartment 12 and module exchange unit 40 each include a vacuum valve in flanges 19 and 52, respectively, i.e. the vacuum valves 54 and 21. Valve 21 is provided, in order to ensure a vacuum-tight closure of the compartment 12, e.g. if no other substrate processing module or no flange cap is mounted at the opening 18. In an exemplary exchange procedure using the present example, flange 52 of vacuum chamber 42 is positioned in front of flange 19. Sealings 30 and 53 are connected to each other for establishing a vacuum-tight connection between compartment 12 and vacuum chamber 42. Then, if vacuum chamber 42 has not been evacuated prior to connecting it to compartment 12, vacuum chamber 42 is now evacuated to a vacuum pressure which approximately corresponds to the pressure inside compartment 12. Further, vacuum valve 54 is opened and the space between vacuum valves 54 and 21 is evacuated. Thereafter, vacuum valve 21 is opened, in order to evacuate the space between vacuum valve 21 and the sputtering cathode module 20 mounted. Now, the sputtering cathode module 20 is removed from the opening 18 as described above and inserted into the module exchange unit 40. Finally, vacuum valves 21 and 54 are closed and the space between these two valves is vented by an air valve (not shown) provided in the vacuum-tight connection. Vacuum chamber 42 is then removed from flange 19.

The effect of the example shown in Fig. 5 is that, before, during and after termination of the exchange procedure, inside of the module exchange unit 40 and of the compartment 12 a vacuum pressure can be maintained. Hence, the coating installation may be operated without an unduly long service break. Further, other new sputtering cathode modules stored inside of the module exchange unit can be maintained under clean vacuum conditions after termination of the exchange procedure. Moreover, because of valve 21, even if opening 18 of the compartment 12 is not closed in a vacuum-tight manner after removal of the sputtering cathode module 20, the vacuum pressure inside of the compartment 12 is maintained. As a result, the same time and cost saving effects as for the examples of Fig. 1 and 2 can be achieved.

A modification of the above examples, and in particular, of the example shown in Fig. 5, includes in the unit communication means and/or in the compartment communication means an individual vacuum pump (not shown) for evacuation. As to the example of Fig. 5, such a vacuum pump may typically be connected to a wall of flange 19 or of flange 52 near the free end thereof, such that the connection to the vacuum pump is located between the vacuum valves 21 and 52. Hence, after connecting compartment 12 to module exchange unit 40 in a vacuum-tight manner, the space between the closed vacuum valves 21 and 54 may be evacuated individually using the vacuum pump connected to the space between vacuum valves 21 and 52. Therefore, the space between vacuum valves 21 and 52 is not evacuated via module exchange unit 40 using vacuum pump 48. Further, the space between vacuum valve 21 and sputtering cathode module 20 may also be evacuated after opening vacuum valve 21, but without opening vacuum valve 54. That means that the module exchange unit 40 may be transported and connected to the compartment 12 while having vacuum valve 54 closed and keeping a vacuum pressure inside the vacuum chamber 42. Moreover, only the spaces between vacuum valves 21 and 54 or between vacuum valve 54 and the sputtering cathode module 20, respectively, have to be evacuated after the vacuum-tight connection between module exchange unit 40 and the compartment 12 has been established. Thereby, the time period required for the exchange procedure, along with the service costs, can be reduced considerably.

In a further variation of the module exchange procedures using the examples illustrated in Fig. 4 and 5, the step of exchanging the sputtering cathode module 20 is modified. In detail, after the sputtering cathode module 20 is dismounted from the opening 18, another sputtering cathode module stored inside of the module exchange unit 80 or 40, respectively, is mounted at the opening 18. Thereafter, in a first alternative procedure, vacuum valve 21 is closed and the space between the vacuum valves 21 and 54 or between vacuum valve 21 and lid 84, respectively, is vented. Then the compartment 12 and the module exchange unit 80 or 40, respectively, are disconnected. Finally, after separation of the compartment 12 and the module exchange unit 80 or 40, respectively, vacuum valve 21 is opened and the feed through ports 25 of the new sputtering cathode module mounted are connected to corresponding lines for water and current supply. A second alternative procedure of this example differs from the above first alternative in that vacuum valve 21 is not closed after mounting the new sputtering cathode module at the opening 18. Hence, during venting of the vacuum-tight connection, also the space between the vacuum valve 21 and the rear part of the new sputtering cathode module is vented. Further, the water and current supply lines may be linked to the feed through ports 25 of the new sputtering cathode module immediately after separation of the compartment 12 and the module exchange unit 80 or 40, respectively.

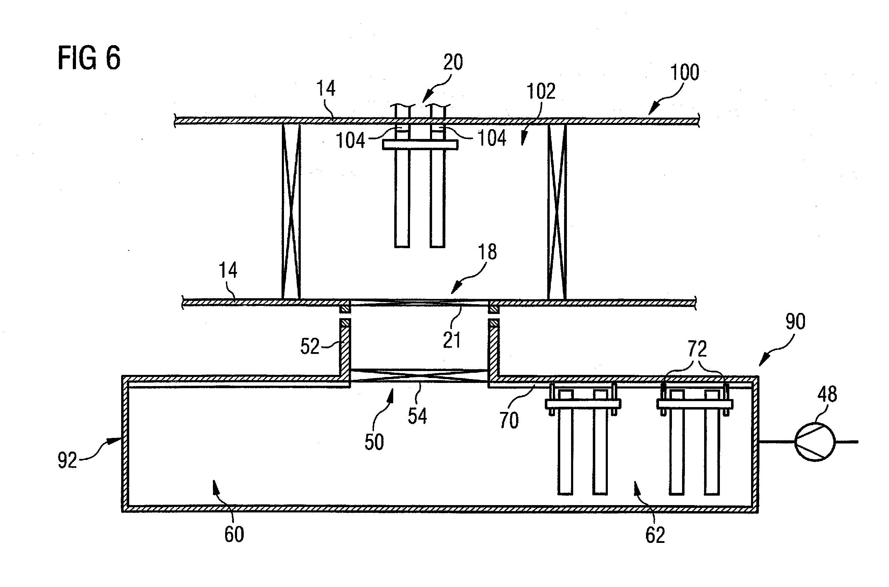

Fig. 6 shows another example of embodiments described herein. In this example, a module exchange unit 90 and a compartment 102 of a coating installation 100 are combined. Compartment 102 differs from compartment 12 in that it has the sputtering cathode module 20 mounted inside of compartment 102 on feed through ports 104 provided at the sidewall 14 opposite to the opening 18. Furthermore, compartment 102 may have the vacuum valve 21 mounted directly in opening 18, as illustrated in Fig. 6. Moreover, as shown in Fig. 6, module exchange unit 90 may differ from module exchange unit 40 shown in Fig. 1 in that the transport system 70 and the bolts 72 are arranged such that the new sputtering cathode modules stored in second storage region 62 have an orientation to be conveniently engaged and handled by the manipulator (not shown), in order to be mounted inside the compartment 102 at the sidewall 14 opposite to the opening 18.

An exemplary module exchange procedure of the example shown in Fig. 6 differs from the module exchange procedure as described for Fig. 5 mainly with respect to the steps of dismounting and mounting of the sputtering cathode module. In detail, at first the vacuum-tight connection between compartment 102 and the evacuated module exchange unit 90 is established. After opening valve 54, evacuating the space between vacuum valves 54 and 21 and opening vacuum valve 21, the sputtering cathode module 20 mounted inside the compartment 102 is released from its feed through ports 104 by the manipulator 75. The latter transports the sputtering cathode module 20 through opening 18 and opening 50 and inserts it into the module exchange unit 90 in which it is transferred into the first storage region 60. Thereafter, a new sputtering cathode module stored in the second storage region 62 of the module exchange unit 90 may be installed on the feed through ports 104 inside the compartment 102. Then, the valves 21 and 54 are closed and the space between these two valves is vented by a vacuum valve (not shown) provided for instance in flange 52. After that, the compartment 100 and the module exchange unit 90 are disconnected and the latter may be transported to another compartment, another module port or another flange of the coating installation 100 or of another vacuum coating installation for service.

Hence, the example shown in Fig. 6 allows for exchanging a substrate processing module mounted inside the compartment of the coating installation or at another inside wall of the compartment, while achieving the same effects as described for the examples of Fig. 1 and 2. That means when using the example of Fig. 6 in a substrate processing module exchange procedure, there is no need for venting the compartment 102 of the vacuum coating installation 100. Moreover, in the module exchange unit 90 according to the example of Fig. 6, the sputtering cathode modules to be mounted can be prepared for mounting and stored for a longer time period under vacuum pressure. Further, after connecting the evacuated module exchange unit 90 and the vacuum coating installation in a vacuum-tight manner as described above, only the interior space of the vacuum-tight connection has to be evacuated. The consequence is a short pumping period during the substrate processing module exchange procedure. Furthermore, the procedure of replacing a substrate processing module by another one may be carried out in one step. In summary, the whole procedure of exchanging a substrate processing module is shortened. Hence, the time period during which the coating installation cannot operate and the total service expenses can be reduced considerably.

In modifications of the above described examples, an additional vacuum chamber which is installed at the sidewall 14 of compartment 10, 100 at or instead of flange 19 shown in Fig. 2 to 5 or in front of the opening 18 shown in Fig. 1 and 6 may be provided. Hence, during the exchange procedure of a substrate processing module, this additional vacuum chamber may be positioned between sealings 30 and 53, i.e. between the compartment 12, 102 and the module exchange unit 40, 80 and 90, respectively. Furthermore, it may include the above mentioned manipulating means or manipulator 75, respectively, for dismounting, mounting, engaging, and transporting the substrate processing module to be exchanged between the compartment 12, 102, and the module exchange unit 40, 80 and 90, respectively.

Furthermore, Fig. 7 shows another modification of the above examples, exemplified for the example shown in Fig. 1. Fig. 7 illustrates a cross sectional side view of the compartment 12 and the corresponding module exchange unit 40 along line A-A indicated in Fig. 1. As shown in Fig. 7, the module exchange unit of embodiments described herein may be provided with transportation means being adapted for transporting the vacuum chamber from one module port to another module port. Typically, the transportation means comprises wheels 120 provided outside at the bottom of the vacuum chamber 42. Moreover, the transportation means may comprise a raise and lowering device 122, for instance hydraulically driven, for adjusting the height of the vacuum chamber 42. Thereby, the module exchange aperture or flange 52 of the module exchange unit 40 can be arranged corresponding to the height of the opening 18 of the compartment 12. This example may also be applied to the module exchange units 80, 90 described above and allows for a more convenient transport of the mobile module exchange units 40, 80 and 90 from one module port to another and from one compartment to another, or even from one coating installation to another. Thereby, the time period and costs required for a service procedure on a plurality of substrate processing modules can be reduced.

It will be appreciated by the skilled person, that the above described examples are not restricted to exchanging sputtering cathode modules of coating installations. Rather, other substrate processing modules or other vacuum modules mounted or to be mounted at a vacuum installation can be installed or exchanged in an analogous way and using a correspondingly adapted module exchange unit. Furthermore, it will be understood by those skilled in the art that in the above embodiments the coating installation will be designed for substrates of specific dimensions. Moreover, the sputtering cathode modules may have a specific size. Therefore, the dimensions of the module exchange unit and the features thereof can be specifically adjusted to those dimensions of the coating installation. Thus, by knowing the dimensions of the substrates and of the substrate processing modules for which the coating installation is designed, the skilled person can determine the correct dimensions of the module exchange unit and the features of the coating installation and of the corresponding module exchange method. Moreover, the coating installations described herein comprise compartments having the substrate processing modules mounted at a sidewall. However, as the skilled person will be aware, the examples and embodiments of module exchange units, of compartments of a coating installation, and of methods as described herein can be adapted to coating installations having the substrate processing modules to be exchanged mounted at another position or another wall of a compartment, e.g. at a top wall.

According to one embodiment of the invention, it is provided a substrate processing module exchange unit for a vacuum coating installation having at least one compartment with one or more substrate processing modules mounted and with a module port, the module exchange unit comprising a vacuum chamber, the vacuum chamber comprising a module exchange aperture and a vacuum-tight unit connection means adapted for establishing a vacuum-tight connection between the module exchange aperture and the compartment around the module port, wherein the vacuum chamber is sized for including at least two substrate processing modules.

In a modification of the above embodiment, the vacuum chamber comprises a first storage region adapted for storing at least one exchanged substrate processing module, a second storage region adapted for storing at least one substrate processing module to be mounted, and a region adjacent to the module exchange aperture.

In a modification of the above embodiment and modification, the vacuum chamber comprises a transfer device adapted for transferring the substrate processing modules inside of the vacuum chamber.

In a modification of any of the above embodiment and modifications, one of the substrate processing modules mounted is mounted at the module port, and one of the at least two substrate processing modules is to be mounted at the module port.

In a modification of any of the above embodiment and modifications, one or more of the substrate processing modules comprises at least one element selected from the group consisting of: a sputtering cathode or a plurality of sputtering cathodes provided on a platform, and a platform being a vacuum flange.

In a modification of any of the above embodiment and modifications, ports of the substrate processing module are vacuum-compatible.

In a modification of any of the above embodiment and modifications, the unit connection means comprises a vacuum sealing which is mounted at the vacuum chamber around the module exchange aperture and corresponds to another vacuum sealing mounted at the compartment around the module port.

In a modification of any of the above embodiment and modifications, the vacuum chamber is provided with manipulating means adapted for performing at least one of the following steps: engaging and manipulating at least one substrate processing module, dismounting at least one substrate processing module to be exchanged, and mounting at least one substrate processing module to be mounted.

In a modification of any of the above embodiment and modifications, the vacuum chamber comprises a transportation means being adapted for transporting the vacuum chamber from one module port to another module port, optionally comprising wheels provided outside at the bottom of the vacuum chamber.

In a modification of any of the above embodiment and modifications, the vacuum chamber comprises a heating device adapted for heating the vacuum chamber.

In a modification of any of the above embodiment and modifications, the unit connection means comprises at least one element selected from the group consisting of: a vacuum valve, a vacuum lock, a slit valve, an air valve, and a vacuum pump.

In a modification of any of the above embodiment and modifications, the interior of the vacuum chamber is connected to a vacuum pump.

In a further embodiment of the invention, it is provided a vacuum coating installation having at least one compartment with one or more substrate processing modules mounted and with a module port, comprising a substrate processing module exchange unit comprising a vacuum chamber, the vacuum chamber comprising a module exchange aperture and a vacuum-tight unit connection means adapted for establishing a vacuum-tight connection between the module exchange aperture and the compartment around the module port, the vacuum chamber being sized for including at least two substrate processing modules, wherein the compartment comprises compartment connection means adapted for establishing a vacuum-tight connection between the module exchange aperture of the substrate processing module exchange unit and the compartment around the module port.

In a modification of the above further embodiment, one of the substrate processing modules mounted is mounted at the module port, and one of the at least two substrate processing modules is to be mounted at the module port.

In a modification of any of the above further embodiment and modification thereof, one or more of the substrate processing modules comprises at least one element selected from the group consisting of: a sputtering cathode or a plurality of sputtering cathodes provided on a platform, a platform being a vacuum flange, and ports being vacuum-compatible.

In a modification of any of the above further embodiment and modifications thereof, the compartment connection means comprises a vacuum sealing which is mounted at the compartment around the module port and corresponds to another sealing mounted at the vacuum chamber of the substrate processing module exchange unit around the module exchange aperture.

In a modification of any of the above further embodiment and modifications thereof, the compartment connection means comprises at least one element selected from the group consisting of: a vacuum valve, a vacuum lock, a slit valve, an air valve, and a vacuum pump.

According to yet another embodiment of the invention, it is provided a method of exchanging a substrate processing module of a vacuum coating installation having at least one compartment with one or more substrate processing modules mounted and with a module port, comprising providing a substrate processing module exchange unit comprising a vacuum chamber having a module exchange aperture, establishing a vacuum-tight connection between the module exchange aperture of the substrate processing module exchange unit and the compartment of the vacuum coating installation around the module port, evacuating the vacuum-tight connection, exchanging a substrate processing module, and removing the substrate processing module exchange unit.

In a modification of the above yet another embodiment, the step of exchanging a substrate processing module comprises at least one of the following steps: dismounting one of the substrate processing modules mounted and inserting the dismounted substrate processing module into the substrate processing module exchange unit in a region adjacent to the exchange aperture, transferring the dismounted substrate processing module into a first storage region adapted for storing at least one exchanged substrate processing module in the substrate processing module exchange unit, transferring in the substrate processing module exchange unit a substrate processing module to be mounted from a second storage region, which is adapted for storing at least one substrate processing module to be mounted, into a region adjacent to the exchange aperture of the substrate processing module exchange unit, and transporting the substrate processing module to be mounted to the module port and mounting the substrate processing module to be mounted.

In a modification of any of the above yet another embodiment and modification thereof, the substrate processing module mounted is dismounted from the module port and the substrate processing module to be mounted is mounted at the module port.

In a modification of any of the above yet another embodiment and modifications thereof, one or more of the substrate processing modules comprises at least one element selected from the group consisting of: a sputtering cathode or a plurality of sputtering cathodes provided on a platform, a platform being a vacuum flange, and ports being vacuum-compatible.

In a modification of any of the above yet another embodiment and modifications thereof, the method is performed using at least one element selected from the group consisting of: the compartment of the vacuum coating installation comprising compartment connection means adapted for establishing a vacuum-tight connection between the module exchange aperture of the substrate processing module exchange unit and the compartment around the module port, the vacuum chamber of the substrate processing module exchange unit comprising a vacuum-tight unit connection means adapted for establishing a vacuum-tight connection between the module exchange aperture and the compartment around the module port, and the vacuum chamber being sized for including at least two substrate processing modules.

In a modification of any of the above yet another embodiment and modifications thereof, of the unit connection means and the compartment connection means at least the unit connection means comprises a vacuum valve, the substrate processing module exchange unit is evacuated before establishing the vacuum-tight connection, and the vacuum-tight connection is evacuated by opening the vacuum valve of the unit connection means.

In a modification of any of the above yet another embodiment and modifications thereof, the compartment connection means comprises a vacuum valve and the vacuum-tight connection is evacuated by evacuating the substrate processing module exchange unit and the vacuum-tight connection together before the vacuum valve of the compartment connection means is opened.

In a modification of any of the above yet another embodiment and modifications thereof, the module exchange aperture of the substrate processing module exchange unit is closable by a lid, and the lid is opened before the step of evacuating the substrate processing module exchange unit and the vacuum-tight connection together.

The written description uses examples to disclose the invention, including the best mode, and also to enable any person skilled in the art to make and use the invention. While the invention has been described in terms of various specific embodiments, those skilled in the art will recognize that the invention can be practiced with modifications within the spirit and scope of the claims. Especially, mutually non-exclusive features of the embodiments and examples described above may be combined with each other. The patentable scope of the invention is defined by the claims, and may include other examples that occur to those skilled in the art. Such other examples are intended to be within the scope of the claims.

## Claims

1. A substrate processing module exchange unit for a vacuum coating installation having at least one compartment with one or more substrate processing modules mounted and with a module port, the module exchange unit comprising a vacuum chamber, the vacuum chamber comprising a module exchange aperture and a vacuum-tight unit connection means adapted for establishing a vacuum-tight connection between the module exchange aperture and the compartment around the module port, wherein the vacuum chamber is sized for including at least two substrate processing modules.

2. The module exchange unit as defined in claim 1, wherein the vacuum chamber comprises at least one of the following elements selected from the group consisting of: a first storage region adapted for storing at least one exchanged substrate processing module, a second storage region adapted for storing at least one substrate processing module to be mounted, and a region adjacent to the module exchange aperture, and a transfer device adapted for transferring the substrate processing modules inside of the vacuum chamber.

3. The module exchange unit as defined in any of the preceding claims,
wherein one or more of the substrate processing modules comprises at least one of the following elements selected from the group consisting of:
a sputtering cathode, a plurality of sputtering cathodes provided on a platform, a platform which is a vacuum flange, and ports being vacuum-compatible.

4. The module exchange unit as defined in any of the preceding claims,
wherein the unit connection means comprises a vacuum sealing which is mounted at the vacuum chamber around the module exchange aperture and corresponds to another vacuum sealing mounted at the compartment around the module port.

5. The module exchange unit as defined in any of the preceding claims,
wherein the vacuum chamber is provided with manipulating means adapted for performing at least one of the following steps: engaging and manipulating at least one substrate processing module, dismounting at least one substrate processing module to be exchanged, and mounting at least one substrate processing module to be mounted.

6. The module exchange unit as defined in any of the preceding claims,
wherein the vacuum chamber comprises a transportation means being adapted for transporting the vacuum chamber from one module port to another module port, optionally comprising wheels provided outside at the bottom of the vacuum chamber.

7. The module exchange unit as defined in any of the preceding claims,
wherein the vacuum chamber comprises at least one element selected from the group consisting of: a heating device adapted for heating the vacuum chamber; in the unit connection means a vacuum valve, a vacuum lock, a slit valve, an air valve, and a vacuum pump; and an interior of the vacuum chamber, which is connected to a vacuum pump.

8. A vacuum coating installation having at least one compartment with one or more substrate processing modules mounted and with a module port, comprising a substrate processing module exchange unit according to one of claims 1 to 7, wherein the compartment comprises compartment connection means adapted for establishing a vacuum-tight connection between the module exchange aperture of the substrate processing module exchange unit and the compartment around the module port.

9. The vacuum coating installation as defined in claim 8, wherein one or more of the substrate processing modules comprises at least one of the following elements selected from the group consisting of: a sputtering cathode or a plurality of sputtering cathodes provided on a platform, a platform which is a vacuum flange, and ports being vacuum-compatible.

10. The vacuum coating installation as defined in claim 8 or 9,
wherein the compartment connection means comprises at least one element selected from the group consisting: a vacuum sealing which is mounted at the compartment around the module port and corresponds to another sealing mounted at the vacuum chamber of the substrate processing module exchange unit around the module exchange aperture, a vacuum valve, a vacuum lock, a slit valve, an air valve, and a vacuum pump.

11. A method of exchanging a substrate processing module of a vacuum coating installation having at least one compartment with one or more substrate processing modules mounted and with a module port, comprising providing a substrate processing module exchange unit comprising a vacuum chamber having a module exchange aperture, establishing a vacuum-tight connection between the module exchange aperture of the substrate processing module exchange unit and the compartment of the vacuum coating installation around the module port, evacuating the vacuum-tight connection, exchanging a substrate processing module, and removing the substrate processing module exchange unit.

12. A method as defined in claim 11,
wherein the step of exchanging a substrate processing module comprises at least one of the following steps:
dismounting one of the substrate processing modules mounted and
inserting the dismounted substrate processing module into the substrate processing module exchange unit in a region adjacent to the exchange aperture; transferring the dismounted substrate processing module into a first storage region adapted for storing at least one exchanged substrate processing module in the substrate processing module exchange unit; transferring in the substrate processing module exchange unit a substrate processing module to be mounted from a second storage region, which is adapted for storing at least one substrate processing module to be mounted, into a region adjacent to the exchange aperture of the substrate processing module exchange unit; and transporting the substrate processing module to be mounted to the module port and mounting the substrate processing module to be mounted.

13. A method as defined in any of claims 11 and 12,
wherein the substrate processing module mounted is dismounted from the module port and the substrate processing module to be mounted is mounted at the module port; and/or
wherein one or more of the substrate processing modules comprises at least one of the following elements selected from the group consisting of:
a sputtering cathode or a plurality of sputtering cathodes provided on a platform, a platform which is a vacuum flange, and ports being vacuum-compatible; and/or
wherein the vacuum coating installation is a vacuum coating installation according to one of claims 9 to 11 and the substrate processing module exchange unit is a substrate processing module exchange unit according to one of claims 1 to 8.

14. A method as defined in any of claims 11 to 13,
wherein the compartment of the vacuum coating installation comprises compartment connection means adapted for establishing a vacuum-tight connection between the module exchange aperture of the substrate processing module exchange unit and the compartment around the module port, and wherein the vacuum chamber of the substrate processing module exchange unit comprises a vacuum-tight unit connection means adapted for establishing a vacuum-tight connection between the module exchange aperture and the compartment around the module port, wherein the vacuum chamber is sized for including at least two substrate processing modules, and
wherein of the unit connection means and the compartment connection means at least the unit connection means comprises a vacuum valve, the substrate processing module exchange unit is evacuated before establishing the vacuum-tight connection, and the vacuum-tight connection is evacuated by opening the vacuum valve of the unit connection means, or
wherein the compartment connection means comprises a vacuum valve, and the vacuum-tight connection is evacuated by evacuating the substrate processing module exchange unit and the vacuum-tight connection together before the vacuum valve of the compartment connection means is opened.

15. Use of a substrate processing module exchange unit according to any of claims 1 to 7 in a method of exchanging a substrate processing module of a vacuum coating installation.
